# EUROPÄISCHE PATENTANMELDUNG

(11) **EP 0 977 262 A2**
(43) Veröffentlichungstag der Anmeldung: **02.02.2000**
(21) Anmeldenummer: 99112844.8
(22) Anmeldetag: 02.07.1999
(51) Int. Cl.: H01L 23/52

(54) **Integrierter Halbleiterchip mit modularen Füllstrukturen**

(30) Priorität: 29.07.1998 DE 19834234
(71) Anmelder: SIEMENS AKTIENGESELLSCHAFT, 80333 München (DE)
(72) Erfinder: Savignac, Dominique, Dr., 85737 Ismaning (DE); Schneider, Helmut, 80993 München (DE)

(57) **Zusammenfassung**

Für einen zuverlässigen Betrieb eines integrierten Halbleiterchips ist es notwendig, das Substratpotential möglichst in allen Bereichen des Chips flächendeckend zu homogenisieren. Zur Verbesserung der Subtratkontaktierung auf dem Chip werden modulare Füllstrukturen (1 bis 5) so gestaltet, daß sie neben der Homogenisierung der Flächenbelegung des Chips eine flächendeckende elektrisch leitende Kontaktierung zwischen dem Substrat (6) und den Metalleiterbahnen einer Metallisierungsebene (5) des Chips bilden. Dadurch wird eine Homogenisierung des Substratpotentials und eine Verbesserung der Wellenleitungseigenschaften der über den Füllstrukturen (1 bis 5) liegenden Verdrahtungsebenen (7) erreicht, ohne daß zu diesem Zweck ein zusätzlicher Prozeßschritt oder eine zusätzliche Chipfläche benötigt wird.

## Beschreibung

Die vorliegende Erfindung betrifft einen integrierten Halbleiterchip nach dem Oberbegriff des Patentanspruchs 1.

Betrachtet man die Fläche (Layoutstruktur) eines integrierten Halbleiterchips, lassen sich aufgrund der Strukturunterschiede in der obersten Schicht im allgemeinen sogenannte aktive Bereiche und inaktive Bereiche erkennen. In den aktiven Bereichen sind beispielsweise Bauelemente oder Funktionsgruppen (z.B. Transistoren, Speicherzellen) angeordnet, die die Funktionalität des Halbleiterchips bewerkstelligen, in den inaktiven Bereichen sind hingegen keine Bauelemente oder Funktionsgruppen enthalten. Moderne Fertigungsprozesse erfordern hinsichtlich des topographischen Aufbaus von integrierten Halbleiterchips insbesondere eine homogene Flächenbelegung in allen relevanten Prozeßebenen vom Substrat bis einschließlich einer ersten Metallisierungsebene. Das bedeutet, daß der strukturelle Aufbau dieser Prozeßebenen in den aktiven und inaktiven Bereichen des Chips weitgehend ähnlich sein soll. Zu diesem Zweck werden innerhalb der inaktiven Bereiche in den oben genannten Prozeßebenen sogenannte modulare Füllstrukturen vorgesehen, die ähnlich aufgebaut sind, wie die Strukturen der aktiven Bereiche. Die Verwendung von modularen Füllstrukturen ist bereits gängige Praxis. Sie werden, nochmals kurz in Schlagworten dargestellt, vor allem aus drei Gründen verwendet:
- Schaffung von gleichen Schichthärten über der gesamten Chipfläche durch homogene Flächenbelegung unterhalb der jeweils obersten Schicht, wichtig hinsichtlich "CMP" (Chemical Mecnanical Polishing), "Dishing",
- Homogenisierung von Belichtungsausleuchtung und Beugungseffekten über der gesamten Chipfläche, "OPE" (Optical Proximity Effect),
- Homogenisierung und Verbesserung des Ätzprozesses über der gesamten Chipfläche, "RIE" (Reaktive Ione Etch), "Micro Loading".

Für den Betrieb des Halbleiterchips ist es erstrebenswert, das Substratpotential des Chips bestmöglich zu homogenisieren. Dadurch wird erreicht, daß das Substratpotential für alle Bauelemente, die auf dem Substrat aufgebracht sind, gleichmäßig verteilt ist. Daraus ergibt sich eine bessere und gleichmäßigere Spannungsversorgung aller über die Chipfläche verteilten Bauelemente. Die Wellenausbreitungseigenschaften von Spannungsimpulsen auf elektrischen Leitern sind über einheitlichem Potential berechenbarer und homogener. Durch ein einheitliches Substratpotential werden deshalb auch die Wellenleitungseigenschaften von darüber liegenden Verdrahtungsebenen verbessert. Bisher wurde versucht, eine Homogenisierung des elektrischen Substratpotentials durch Verwendung von EPI-Substraten und durch zusätzliche Substratkontakte in den einzelnen Schaltungen zu erreichen. Durch Verwendung von EPI-Substraten kann außerdem der bekannte "Latch-up"-Effekt verkleinert werden. Ein Nachteil dieses Vorgehens ist, daß zur Aufbringung der Epitaxie-Schicht auf das Substrat ein zusätzlicher kostspieliger Prozeßschritt beim Herstellungsprozeß notwendig ist.

Die Aufgabe der vorliegenden Erfindung ist es, eine flächendeckende Homogenisierung der Substratpotentialverhältnisse auf einem integrierten Halbleiterchip zu erreichen. Dabei soll der entsprechende Aufwand beim Herstellungsprozeß des Chips möglichst gering gehalten werden.

Die Aufgabe wird gelöst durch einen integrierten Halbleiterchip mit modularen Füllstrukturen nach den Merkmalen des Patentanspruchs 1.

Vorteilhafte Aus- und Weiterbildungen sind in Unteransprüchen gekennzeichnet.

Im folgenden wird die Erfindung anhand der in der Zeichnung dargestellten Figuren näher erläutert.

Es zeigen:
- Figur 1: einen Querschnitt von modularen Füllstrukturen bis einschließlich einer Metallisierungsebene
- Figur 2: eine Draufsicht (Layoutstruktur) eines Teils einer Chipfläche, über die sich modulare Füllstrukturen erstrecken

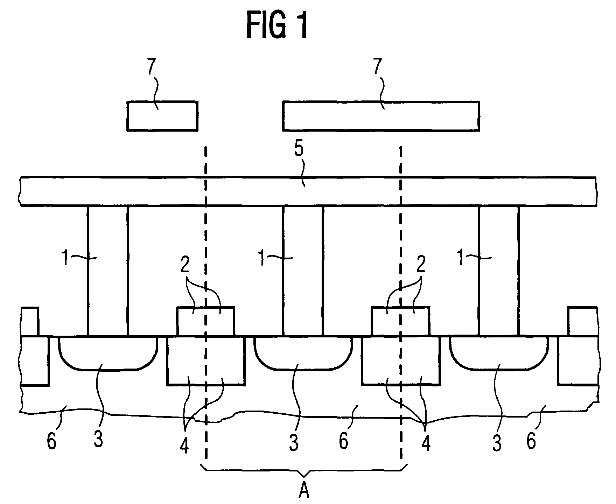

Figur 1 zeigt schematisch einen Querschnitt von modularen Füllstrukturen 1 bis 5 aller relevanten Prozeßebenen bis einschließlich den Metalleiterbahnen einer Metallisierungsebene 5. Um die eingangs genannten Aufgaben möglichst gut erfüllen zu können, sollte der Aufbau und die Struktur der modularen Füllstrukturen 1 bis 5 dem Aufbau und der Struktur der aktiven Bereiche des Chips gleichen. Dadurch ist die Anordnung der im Querschnitt dargestellten unterschiedlichen Füllstrukturen 1 bis 5 weitgehend festgelegt.

In den Bereichen der Chipfläche, über die sich modulare Füllstrukturen 1 bis 5 erstrecken, sind eine Vielzahl von elektrisch leitenden Kontaktstellen 1 zwischen den Metalleiterbahnen der Metallisierungsebene 5 una dem Substrat 6 angeordnet. Die Füllstrukturen bestehen aus einer Vielzahl von untereinander gleichen Abschnitten A. In jedem der Abschnitte A ist eine elektrisch leitende Kontaktstelle 1 zwischen den Metalleiterbahnen der Metallisierungsebene 5 und dem Substrat 6 vorhanden. Jeder der untereinander gleichen Abschnitte A umfaßt ein anteiliges Substrat 6 entsprechend der Größe des jeweiligen Abschnitts A, Gebiete mit Polysilizium 2, die sich über dem Substrat 6 befinden, ein Dotierungsgebiet 3, das im Substrat und beabstandet von den Gebieten mit Polysilizium 2 angeordnet ist, und eine elektrisch leitende Kontaktstelle 1, die mit dem Dotierungsgebiet 3 und den Metalleiterbahnen der Metallisierungsebene 5 elektrisch leitend verbunden ist. Im Substrat 6 sind unterhalb der Gebiete mit Polysilizium 2 jeweils mit Oxid gefüllte Gräben 4 angeordnet. Die Gebiete mit Polysilizium 2 und die mit Oxid gefüllten Gräben 4 benachbarter Abschnitte A der Vielzahl der untereinander gleichen Abschnitte A der Füllstrukturen sind als jeweils gemeinsame Gebiete ausgeführt.

Bisher wurden Füllstrukturen zur Homogenisierung der Flächenbelegung eines Chips elektrisch nicht benutzt. Daher bestanden auch in den Bereichen einer Chipfläche, über die sich Füllstrukturen erstrecken, keine elektrisch leitenden Verbindungen zwischen dem Substrat 6 und darüber befindlichen Prozeßebenen. In den Bereichen der Chipfläche, über die sich modulare Füllstrukturen erstrecken, sind Metalleiterbahnen der Metallisierungsebene 5 aufgebracht. Um das Substratpotential des Chips zu homogenisieren, sind diese über elektrisch leitende Kontaktstellen 1 und Dotierungsgebiete 3 mit dem Substrat 6 elektrisch leitend verbunden. Die Dotierungsgebiete 3 umfassen dabei Gebiete mit hochdotiertem Silizium. Die Metalleiterbahnen der Metallisierungsebene 5 sind im Betrieb des Halbleiterchips ihrerseits auf Bezugspotential (beispielsweise "GND")

Durch die flächendeckende elektrisch leitende Verbindung zwischen den Metalleiterbahnen der Metallisierungsebene 5 und dem Substrat 6 wird das Substratpotential durchgehend auf Bezugspotential gehalten. Daneben wird die Homogenisierung der Flächenbelegung des Chips durch die aufgebrachten Meralleiterbahnen der Metallisierungsebene 5 weiter verbessert. Die Spannungsversorgung aller über der gesamten Chipfläche auf dem Substrat 6 aufgebrachten Bauelemente wird homogener. Durch ein einheitliches Substratpotential sind die Leitungskapazitäten zwischen einer über den Füllstrukturen 1 bis 5 befindlichen Verdrahtungsebene 7 und dem Substrat 6, die mitbestimmend für die Wellenleitungseigenschaften in der Verdrahtungsebene 7 sind, über die gesamte Chipfläche gleichmäßiger verteilt. Dadurch werden die Wellenleitungseigenschaften in der Verdrahtungsebene 7 homogenisiert und verbessert. Dies wirkt unterstützend hinsichtlich eines zuverlässigen Betriebs des Chips, da Wellenausbreitungseigenschaften von Spannungs- oder Stromimpulsen auf dem Chip berechenbarer werden. Durch homogenes Substratpotential wird außerdem der "Lauch-up"-Effekt wirksam unterdrückt.

Durch eine derartige Anordnung ist für eine Homogenisierung des Substratpotentials weder eine zusätzliche Chipfläche noch ein zusätzlicher Prozeßschritt notwendig. Es wird keine zusätzliche Chipfläche benötigt, da die modularen Füllstrukturen 1 bis 5, die, wie oben dargestellt, bereits zur Homogenisierung der Flächenbelegung verwendet werden, nur eine weitere Funktion erhalten, indem sie nun auch für elektrische Zwecke benutzt werden. Es erfordert keinen zusätzlichen Prozeßschritt, da bisher vorgesehene Füllmuster nunmehr in Form der Kontaktstellen 1 elektrisch leitend sind, in ihrer geometrischen Form und Anordnung jedoch gleich bleiben. Elektrische Kontakte sind notwendig in den aktiven Bereichen des Chips, beispielsweise zur Kontaktierung von Bauelementen, so daß der dazu notwendige Prozeßschritt lediglich auf die Flächen des Chips ausgedehnt wird, über die sich Füllstrukturen 1 bis 5 erstrecken. Die elektrisch leitenden Kontaktstellen 1 entsprechen in ihrem Aufbau dabei den Kontakten in den aktiven Bereichen des Chips. Der Prozeßschritt zur Anordnung der Metalleiterbahnen der Metallisierungsebene 5 entspricht dem Prozeßschritt, in dem die Merallisierungsschicht in den aktiven Bereichen des Chips aufgebracht wird.

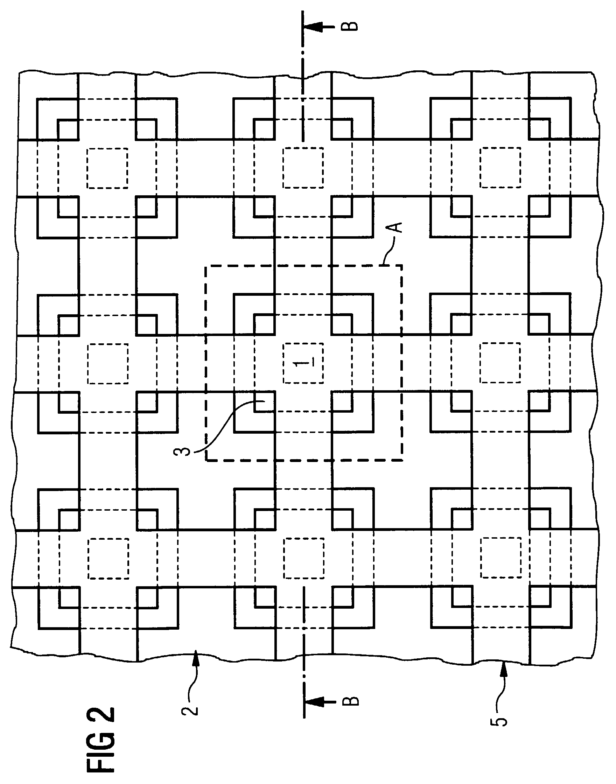

Figur 2 zeigt eine Layoutstruktur eines Teils einer Chipfläche, über die sich Füllstrukturen erstrecken. Ein Querschnitt der Füllstrukturen entlang einer Linie B-B ist in der Darstellung nach Figur 1 schematisch gezeigt. Ein Abschnitt A aus Figur 1 ist in Figur 2 mit einer gestrichelten Linie gekennzeichnet. Anhand der in Figur 1 im Querschnitt dargestellten relevanten Prozeßebenen des Chips wird eine mögliche Ausführung einer Layoutstruktur mit modularen Füllstrukturen dargestellt.

Das Substrat des Halbleiterchips weist (nicht vollständig sichtbare) mit Oxid gefüllte Gräben 4 auf, auf denen Gebiete mit Polysilizium 2 aufgebracht sind, wobei diese nur einen Teil der Fläche der mit Oxid gefüllten Gräben 4 bedecken. Die mit Oxid gefüllten Gräben 4 und die darauf aufgebrachten Gebiete mit Polysilizium 2 sind zusammenhängend über die gesamten Bereiche der Chipfläche, über die sich die Füllstrukturen erstrecken, angeordnet, wobei sie Bereiche umschließen, die keine mit Oxid gefüllten Gräben 4 und Gebiete mit Polysilizium 2 aufweisen und die in regelmäßigen Abständen angeordnet und parallel ausgerichtet sind. Innerhalb eines solchen Bereichs, der von Gebieten mit Polysilizium 2 und mit Oxid gefüllten Gräben 4 umgeben ist, sind Dotierungsgebiete 3 im Substrat 6 des Halbleiterchips angeordnet. Innerhalb eines solchen Bereichs eines Dotierungsgebiets 3 sind auf das Dotierungsgebiet 3 elektrisch leitende Kontaktstellen 1 aufgebracht, die über das jeweilige Dotierungsgebiet 3 eine elektrisch leitende Kontaktierung zum Substrat 6 des Halbleiterchips herstellen, wobei sie nur einen Teil dieses Bereichs bedecken. Bandförmige Metalleiterbahnen der Metallisierungsebene 5, die kreuzförmig in regelmäßigen Abständen und je Richtung parallel zueinander ausgerichtet sind, sind derart angeordnet, daß die jeweils rechtwinklig zueinander liegenden Metalleiterbahnen der Metallisierungsebene 5 Kreuzungsflächen bilden, die sich jeweils über einem der Kontaktestellen 1 befinden und diese bedecken. Die Metalleiterbahen der Metallisierungsebene 5 sind mit den Kontaktstellen 1 im Bereich der Kreuzungsflächen elektrisch leitend verbunden.

Im Ausführungsbeispiel besteht das Dotierungsgebiet 3 aus p⁺-dotiertem Silizium, das Substrat 6 aus p⁻-dotiertem Silizium. Es ist jedoch auch eine Ausführung mit n⁺-dotiertem Silizium im Dotierungsgebiet 3 und n⁻-dotiertem Silizium im Substrat 6 möglich.

## Patentansprüche

1. Integrierter Halbleiterchip mit einem Substrat (6) und darauf angeordneten modularen Füllstrukturen (1 bis 5), die Metalleiterbahnen einer Metallisierungsebene (5) einschließen und die derart beschaffen sind, daß in den Bereichen der Chipfläche, über die sich die Füllstrukturen (1 bis 5) erstrecken, eine Vielzahl von elektrisch leitenden Kontaktstellen (1) zwischen den Metalleiterbahnen der Metallisierungsebene (5) und dem Substrat (6) vorhanden sind.

2. Integrierter Halbleiterchip nach Anspruch 1,
**dadurch gekennzeichnet,** daß die modularen Füllstrukturen aus einer Vielzahl von untereinander gleichen Abschnitten (A) bestehen, und daß in jedem der Abschnitte (A) eine elektrisch leitende Kontaktstelle (1) zwischen den Metalleiterbahnen der Metallisierungsebene (5) und dem Substrat (6) vorhanden ist.

3. Integrierter Halbleiterchip nach Anspruch 2,
**dadurch gekennzeichnet,** daß jeder der untereinander gleichen Abschnitte (A)
- ein anteiliges Substrat (6) entsprechend der Größe des jeweiligen Abschnitts (A),
- Gebiete mit Polysilizium (2), die sich über dem Substrat (6) befinden,
- ein Dotierungsgebiet (3), das im Substrat und beabstandet von den Gebieten mit Polysilizium (2) angeordnet ist, und
- eine elektrisch leitende Kontaktstelle (1), die mit dem Dotierungsgebiet (3) und den Metalleiterbahnen der Metallisterungsebene (5) elektrisch leitend verbunden ist,
umfaßt.

4. Integrierter Halbleiterchip nach Anspruch 3,
**dadurch gekennzeichnet,** daß im Substrat (6) unterhalb der Gebiete mit Polysilizium (2) jeweils mit Oxid gefüllte Gräben (4) angeordnet sind.

5. Integrierter Halbleiterchip nach Anspruch 3,
**dadurch gekennzeichnet,** daß das Dotierungsgebiet (3) und das Substrat (6) aus dotiertem Silizium gleicher Dotierungspolarität besteht, wobei das Silizium im Dotierungsgebiet (3) mit hoher Konzentration und im Substrat (6) mit niedriger Konzentration dotiert ist.

6. Integrierter Halbleiterchip nach Anspruch 4,
**dadurch gekennzeichnet,** daß die Gebiete mit Polysilizium (2) und die mit Oxid gefüllten Gräben (4) benachbarter Abschnitte (A) der Vielzahl der untereinander gleichen Abschnitte (A) der Füllstrukturen als jeweils gemeinsame Gebiete ausgeführt sind.

7. Integrierter Halbleiterchip nach einem der vorhergehenden Ansprüche,
**dadurch gekennzeichnet,** daß in den Bereichen der Chipfläche, über die sich die Füllstrukturen (1 bis 5) erstrecken, die Füllstrukturen (1 bis 5) folgende Layoutstruktur aufweisen:
- das Substrat (6) des Halbleiterchips weist mit Oxid gefüllte Gräben (4) auf, auf denen Gebiete mit Polysilizium (2) aufgebracht sind, wobei diese nur einen Teil der Fläche der mit Oxid gefüllten Gräben (4) bedecken,
- die mit Oxid gefüllten Gräben (4) und die darauf aufgebrachten Gebiete mit Polysilizium (2) sind zusammenhängend über die gesamten Bereiche der Chipfläche, über die sich die Füllstrukturen erstrecken, angeordnet, wobei sie Bereiche umschließen, die keine mit Oxid gefüllten Gräben (4) und Gebiete mit Polysilizium (2) aufweisen und die in regelmäßigen Abständen angeordnet und parallel ausgerichtet sind,
- innerhalb eines solchen Bereichs, der von Gebieten mit Polysilizium (2) und mit Oxid gefüllten Gräben (4) umgeben ist, sind Dotierungsgebiete (3) im Substrat (6) des Halbleiterchips angeordnet,
- innerhalb eines solchen Bereichs eines Dotierungsgebiets (3) sind auf das Dotierungsgebiet (3) elektrisch leitende Kontaktstellen (1) aufgebracht, die über das jeweilige Dotierungsgebiet (3) eine elektrisch leitende Kontaktierung zum Substrat (6) des Halbleiterchips herstellen, wobei sie nur einen Teil dieses Bereichs bedecken,
- bandförmige Metalleiterbahnen der Metallisierungsebene (5), die kreuzförmig in regelmäßigen Abständen und je Richtung parallel zueinander ausgerichtet sind, sind derart angeordnet, daß die jeweils rechtwinklig zueinander liegenden Metallleiterbahnen der Metallisierungsebene (5) Kreuzungsflächen bilden, die sich jeweils über einem der elektrisch leitenden Kontaktstellen (1) befinden und diese bedecken,
- die Metallleiterbahnen der Metallisierungsebene (5) sind mit den elektrisch leitenden Kontaktstellen (1) im Bereich der Kreuzungsflächen elektrisch leitend verbunden.
